# EUROPEAN PATENT SPECIFICATION

(11) **EP 2 505 344 B1**
(45) Date of publication and mention of the grant of the patent: **23.05.2018**
(21) Application number: 11766198.3
(22) Date of filing: 08.04.2011
(51) Int. Cl.: B41M 1/24, H05K 3/12, B29C 43/26, B29C 43/22, B82Y 30/00, B29C 43/28

(54) **METHOD FOR MANUFACTURING A FILM PRODUCT USING THERMAL ROLL IMPRINTING AND BLADE COATING, AND SECURITY FILM AND FILM-INTEGRATED ELECTRIC DEVICE USING SAME**
VERFAHREN ZUR HERSTELLUNG EINES FILMPRODUKTS MIT WÄRMEROLLENPRÄGUNG UND KLINGENBESCHICHTUNG SOWIE SICHERHEITSFILM UND IN DEN FILM INTEGRIERTE ELEKTRISCHE VORRICHTUNG DAMIT
PROCÉDÉ POUR FABRIQUER UN PRODUIT DE FILM À L'AIDE D'UNE IMPRESSION PAR ROULEAU THERMIQUE ET D'UN COUCHAGE À LA LAME, ET FILM DE SÉCURITÉ ET DISPOSITIF ÉLECTRIQUE À FILM INTÉGRÉ L'UTILISANT

(30) Priority: 09.04.2010 KR 20100032810
(43) Date of publication of application: 03.10.2012
(73) Proprietor: Korea Institute Of Machinery & Materials, Yuseong-gu Daejeon 305-343 (KR)
(72) Inventor: JO, Jeong-Dai, Daejeon 305-742 (KR); YU, Jong-Su, Daejeon 305-343 (KR); YOON, Seong-Man, Yeongi-gun Chungcheongnam-do 339-757 (KR); KIM, Dong-Soo, Daejeon 302-280 (KR)
(74) Representative: Delorme, Nicolas
(86) International application number: PCT/KR2011/002505
(87) International publication number: WO 2011/126347

(56) References cited:
- EP-A2- 1 972 997
- WO-A1-99/16601
- KR-A- 20030 073 516
- KR-A- 20080 026 210
- KR-A- 20080 085 773
- KR-B1- 100 753 591
- US-A- 3 562 037
- US-A- 3 562 037
- US-A- 4 682 415
- US-A- 5 609 704
- US-A1- 2005 255 232
- US-A1- 2007 022 602

## Description

### BACKGROUND OF THE INVENTION

### (a) Field of the Invention

The present invention relates to a method of manufacturing a film product using thermal roll imprinting and blade coating, and a security film and a film integral electric device using the same.

### (b) Description of the Related Art

For example, a security film is attached to a front surface of a display device and is provided with a partition having a fine pattern with a height on the attached transparent film to partially block image light emitted from the display device, thus implementing security of the display device.

A screen print method forms a partition having a fine pattern on a transparent film to a predetermined height through an overlapping print process repeatedly performing the same process. As the height of the partition of the fine pattern on the transparent film is increased, a screen pressure applied to the partition is increased. Accordingly, even though overlapping print is repeated, the height of the partition of the fine pattern is not additionally increased, but instead the partition expands to the sides.

The screen print method uses a material having high viscosity, and it is difficult to form the partition of the fine pattern in a desired form on the transparent film due to a high viscosity characteristic. For example, when the overlapping print is performed by the screen print method, the cross-section of the partition is not formed to be an ideal square or rectangle but a triangle or trapezoid. In the cross-section of the partition, a portion deviating from the quadrangle range excessively blocks light radiated in the display device to reduce transmission performance, and a portion omitted from the quadrangle range does not sufficiently block light radiated in the display device to reduce security performance.

Further, when the partition of the fine pattern is formed by the screen print method, since it is difficult to form a crossed portion of the partition, the partition is formed to have a straight line shape. The security film having the partition formed to have the straight line shape limits a security direction (for example, left and right or upper and lower directions).

In the case where a print-based electric device is manufactured on a flexible film, it is difficult to form a multi-layered structure and it is difficult to manufacture an electric device using the aforementioned print process due to a height of a primary printed pattern. In this case, the degree of precision is reduced as compared to a semiconductor process.

US-A-2007 022 602 discloses a method of forming a flexible circuit involving a preparing step, an imprinting step to form a groove of a fine pattern by using rolls, and a blading step of filling a material of a paste state by using a doctor blade.

US-A-2005 255 232 discloses a method of applying a protective coating to a flex circuit with conductive traces by using a roller having the protective coating in a pattern.

KR-B-1007 53 591 discloses a security film for a display device and a manufacturing method thereof.

EP-A-1 972 997 and US-A-3 562 037 disclose imprinting methods by using thermal rolls.

### SUMMARY OF THE INVENTION

The present invention has been made in an effort to provide a method of manufacturing a film product using thermal roll imprinting and blade coating, and a security film and a film integral electric device using the same. This objective is achieved by the method according to appended claim 1, the security film according to claim 9 and the electric device according to claim 10. Preferred embodiments of the invention are defined in the dependent claims. An exemplary embodiment of the present invention provides a method of manufacturing a film product using thermal roll imprinting and blade coating, including: a preparing step of preparing a first transparent film; an imprinting step of transporting the first transparent film between a thermal roll provided with an imprint mask and a support roll to form a groove of a fine pattern on the first transparent film; and a blading step of filling a filling material of a paste state having at least one property of light blocking and conductivity in the groove of the first transparent film by a doctor blade.

The method of manufacturing a film product using thermal roll imprinting and blade coating according to the exemplary embodiment of the present invention may further include, after the blading step, a laminating step of laminating a second transparent film on the first transparent film to cover the filling material.

The preparing step may prepare any one of a polyethylene terephthalate (PET) film, a polyethylene naphthalate (PEN) film, a polyether sulfone (PES) film and a polycarbonate (PC) film as the first transparent film to perform surface treatment.

The blading step may fill a black pigment having a light blocking property in the groove. The blading step may fill a conductive ink in the groove. The blading step may fill an Ag paste that is the conductive ink in the groove. The doctor blade may be formed of any one of a metal blade, a ceramic blade and a squeegee.

The laminating step may perform laminating of any one of a polyethylene terephthalate (PET) film, a polyethylene naphthalate (PEN) film, a polyether sulfone (PES) film and a polycarbonate (PC) film as the second transparent film by a roll-to-roll or roll-to-plate manner.

Another exemplary embodiment of the present invention provides a security film including: a first transparent film where a groove of a predetermined fine pattern is formed on one surface thereof by thermal roll imprinting; and a partition formed by a black pigment filled in the groove.

The security film according to the exemplary embodiment of the present invention includes a second transparent film covering the partition to be laminated on the first transparent film.

The first transparent film and the second transparent film may be formed of any one of a polyethylene terephthalate (PET) film, a polyethylene naphthalate (PEN) film, a polyether sulfone (PES) film and a polycarbonate (PC) film.

Yet another exemplary embodiment of the present invention provides a security film including a first transparent film; a light blocking portion formed by performing filling in a groove of a predetermined fine pattern of the first transparent film; a light transmission portion having the same height as the light blocking portion and set by the first transparent film between the light blocking portions; and a second transparent film laminated on the light blocking portion and the light transmission portion.

Still another exemplary embodiment of the present invention provides a film integral electric device including: a first transparent film where a groove of a predetermined fine pattern is formed on one surface thereof by thermal roll imprinting; an electric device formed by conductive ink filled in the groove by blading of a doctor blade; and a second transparent film covering the electric device to be laminated on the first transparent film.

The conductive ink may be formed of an Ag paste.

According to the exemplary embodiments of the present invention, as described above, there is an effect of forming a partition or an electric device of a fine pattern between first and second transparent films by imprinting a groove of a fine pattern on a first transparent film by a thermal roll provided with an imprint mask, filling the groove by blading a black pigment or conductive ink by a doctor blade, and laminating a second transparent film on the first transparent film. An EMI blocking filter, a radio frequency identification (RFID) tag and a grid mesh for a transparent electrode may be formed by using conductive ink.

The thermal roll provided with the imprint mask facilitates a process of forming the groove of the fine pattern on the first transparent film as a continuous process. Accordingly, it is possible to perform mass production of a security film and a film integral electric device. If the imprinted fine pattern groove of the first transparent film is filled with the black pigment, the security film is made, and if the groove is filled with conductive ink, the film integral electric device is made.

The shape of the imprint mask and the imprinting condition set the depth and uniformity of the groove, such that the height and uniformity of the partition and the electric device formed by filling the groove are controlled. The imprint mask basically has an electroform mask, and when the mask is formed, a precision process such as lithography and etching is included, such that the imprint mask has a pattern formed in a scale of several to several tens micrometers or nanometers. That is, the pattern of the imprint mask may be formed in a film through an imprint process, which facilitates manufacturing of a high-precision print-based electronic device. The partition of the fine pattern formed on the first transparent film is formed to have a straight line or cross shape according to the shape of the pattern of the imprint mask, and the electric device of the fine pattern is variously formed to have a straight line, circle or quadrangle shape. Further, the height of the fine pattern may be more finely formed.

The partition or the electric device is formed by filling the groove of the fine pattern by performing blading of the black pigment or conductive ink by the doctor blade. Accordingly, it is easy to form the partition or the electric device. In addition, when the electric device is manufactured by using a print process, the doctor blade primarily forms a portion of the partition or the electric device in the film, and as a result, when secondary print is performed, the print may start on a flat surface. Accordingly, it is possible to form a partition or an electronic device having a multi-layered structure having a high precision.

### BRIEF DESCRIPTION OF THE DRAWINGS

FIG. 1 is a flowchart of a method of manufacturing a film product using thermal roll imprinting and blade coating according to an exemplary embodiment of the present invention.
FIG. 2 illustrates a process of laminating a second transparent film on a first transparent film of FIG. 1 by a roll-to-roll manner.
FIG. 3 illustrates a process of laminating the second transparent film on the first transparent film of FIG. 1 by a roll-to-plate manner.
FIG. 4A and FIG. 4B are perspective views of a security film manufactured by the manufacturing method of FIG. 1.
FIG. 5 is a perspective view of a film integral electric device manufactured by the manufacturing method of FIG. 1.

### <Description of Reference Numerals>

| | |
|---|---|
| 1, 2: First and second transparent films | 10, 60: Security film |
| 11: Partition | 12: Groove |
| 21: Imprint mask | 22: Thermal roll |
| 23: Support roll | 31: Doctor blade |
| 41: Pressure roll | 42: Support roll |
| 43: Support plate | 50: Film integral electric device |
| 51: Electric device | D: Depth |
| M: Filling material | H: Height of protrusion |
| H1: Height of partition | H2: Height of electric device |

### DETAILED DESCRIPTION OF THE EMBODIMENTS

The present invention will be described more fully hereinafter with reference to the accompanying drawings, in which exemplary embodiments of the invention are shown. The drawings and description are to be regarded as illustrative in nature and not restrictive. Like reference numerals designate like elements throughout the specification.

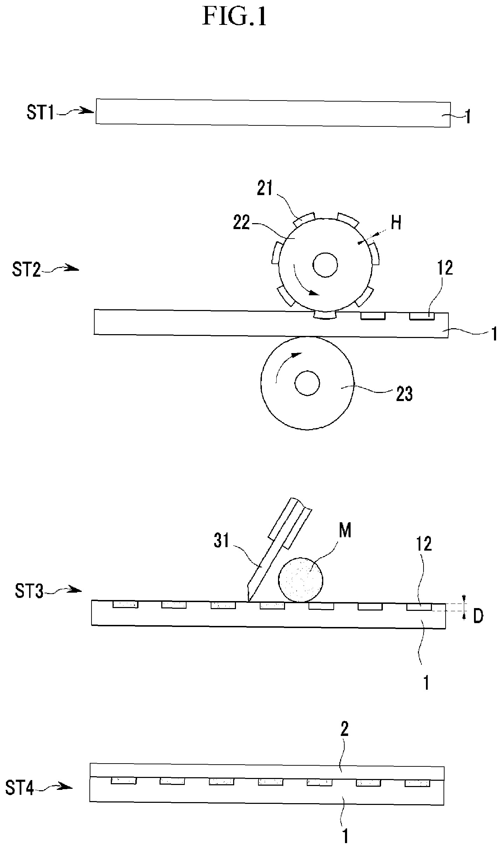

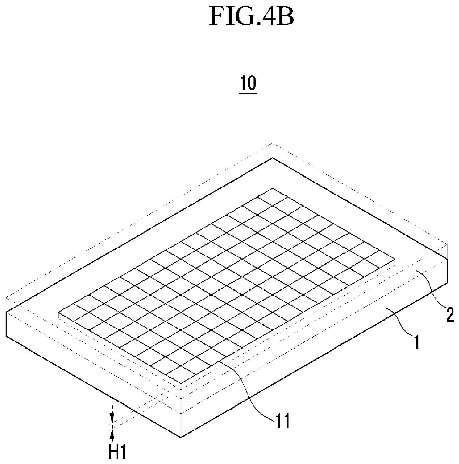

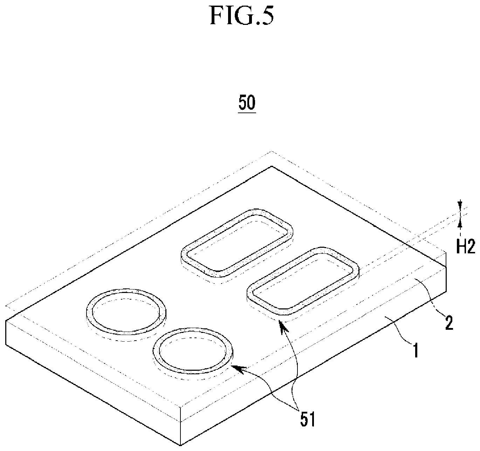

FIG. 1 is a flowchart of a method of manufacturing a film product using thermal roll imprinting and blade coating according to an exemplary embodiment of the present invention (hereinafter, referred to as "method of manufacturing a film product"). According to the method of manufacturing the film product according to the exemplary embodiment, a security film 10 (see FIG. 4B) or a film integral electric device 50 (see FIG. 5) is manufactured using thermal roll imprinting or blade coating. The film integral electric device 50 includes an EMI blocking filter, a radio frequency identification (RFID) tag, a grid mesh for a transparent electrode or the like.

Referring to FIG. 1, the method of manufacturing the film product may include a preparing step ST1 and an imprinting step ST2, and may further include a laminating step ST3. The preparing step ST1 prepares an imprinting process by surface treating a first transparent film 1 that is a target of thermal roll imprinting. The first transparent film 1 is formed of a transparent film imprinted in a state where heat and pressure are applied, that is, capable of being thermal imprinted. For example, the first transparent film 1 may be formed of a polyethylene terephthalate (PET) film, a polyethylene naphthalate (PEN) film, a polyether sulfone (PES) film or a polycarbonate (PC) film.

The imprinting step ST2 transports the first transparent film 1 between a thermal roll 22 and a support roll 23 pressed and supported each other in a heating state, and imprints a groove 12 of a fine pattern on the first transparent film 1. The thermal roll 22 is provided with an imprint mask 21 for forming the groove 12 of the fine pattern on the first transparent film 1. That is, the imprint mask 21 has a corresponding fine pattern corresponding to the groove 12 of the fine pattern.

Since the imprint mask 21 may be provided with the corresponding fine pattern having a protrusion height (H), a line width and a line interval in a nanometer size, the groove 12 of the fine pattern may be formed to have a nanometer size depth (D) in the first transparent film 1, and the depth (D) of the imprinted groove 12 and uniformity of the groove 12 may be controlled. That is, a known screen printing method sets the height of protrusion of the fine pattern, the line width and the line interval to about 30 micrometers. Hereinafter, the height (H) will be described as an example. On the other hand, since the height (H) of the protrusion of the imprint mask 21 is 30 micrometers or less, the groove 12 of the fine pattern is formed in a depth (D) of 30 micrometers or less. For example, the imprint mask 21 basically has an electroform mask, and when the mask is formed, a precision process such as lithography and etching is included, such that the imprint mask has a pattern formed in a scale of several to several tens micrometers or nanometers. That is, the pattern of the imprint mask 21 may be formed in a film through an imprint process, and facilitates manufacturing of a high-precision print-based electronic device.

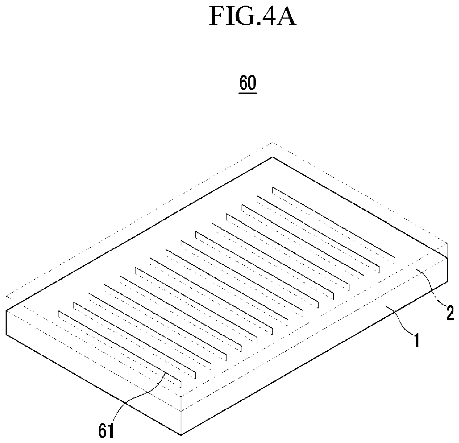

The thermal roll 22 provided with the imprint mask 21 and the support roll 23 may form the groove 12 of the fine pattern on the first transparent film 1 by a continuous process, such that the first transparent film 1 is imprinted in a large quantity. With respect to the shape of the corresponding fine pattern formed on the imprint mask 21, the fine pattern of the groove 12 imprinted on the first transparent film 1 is variously formed to have a straight line (see FIG. 4A) or cross (see FIG. 4B) shape.

The height (H) of the protrusion of the corresponding fine pattern formed in the imprint mask 21 sets the depth (D) of the groove 12 imprinted on the first transparent film 1 (for example, the height H1 of a partition 11 in the security film 10 and the height H2 of an electric device 51 in the film integral electric device 50). Accordingly, an exemplary embodiment may easily control the height (H1) (see FIG. 4B) of the partition 11 in the security film 10 and the height (H2) (see FIG. 5) of the electric device 51 in the film integral electric device 50 by setting the height (H) of the protrusion of the imprint mask 21.

The blading step ST3 fills the fine pattern groove 12 of the first transparent film 1 by blading a filling material (M) of a paste state by a doctor blade 31. The filling material (M) may be variously selected according to the kind of film product that is a manufacturing target. The exemplary embodiment exemplifies a material having a light blocking property or conductivity as the filling material (M). That is, when the security film 10 is manufactured, the filling material (M) may be a black pigment, and when the film integral electric device 50 is manufactured, the filling material (M) may be conductive ink.

The blading step ST3 fills the black pigment having the light blocking property when the security film 10 is manufactured. The black pigment is an example having a light blocking property, and the filling material (M) may further include a pigment having another color and a light blocking property. The filling material (M), that is, the black pigment, forms the partition 11 that is a light blocking portion blocking light radiated from a display device (not shown) in the security film 10. Accordingly, the first transparent film 1 includes a light transmission portion set between the adjacent partitions 11.

The blading step ST3 is a process of filling the groove 12 by blading the filling material (M) by the doctor blade 31, and forms the partition 11 of the security film 10, and thus may facilitate formation of the partition 11 of the fine pattern on the first transparent film 1 and reduce a process time for forming the partition 11 as compared to a known art where a print process or a deposition process is applied.

The security film 10, as described above, may be completed by filling the groove 12 of the first transparent film 1 with the filling material (M), or may be formed by further providing a second transparent film 2 to be described below.

Further, the blading step ST3 fills conductive ink having conductivity, for example, an Ag paste, when the film integral electric device 50 is manufactured. The conductive ink and the Ag paste are an example of a matter having conductivity, and the filling material (M) may further include a metal paste such as Au, Al and Cu having conductivity. The filling material (M), that is, conductive ink, forms the electric device 51 that is a conductive portion in the film integral electric device 50. Accordingly, the first transparent film 1 further includes a non-conductive portion set between the electric devices 51. The electric device 51 and the first transparent film 1 form the same flat surface as surfaces thereof, which facilitates formation of a separate layer (not shown) on the electric device 51.

The blading step ST3 is a process of filling the groove 12 by blading the filling material (M) by the doctor blade 31, and forms the electric device 51 of the film integral electric device 50, and thus may facilitate formation of the electric device 51 of the fine pattern on the first transparent film 1 and reduce a process time for forming the electric device 51 as compared to a known art where a print process or a deposition process is applied.

The laminating step ST4 covers the filling material (M) with the second transparent film 2 and laminates the second transparent film 2 on the first transparent film 1, thereby completing the security film 10 or the film integral electric device 50. The second transparent film 2 may be formed of a polyethylene terephthalate (PET) film, a polyethylene naphthalate (PEN) film, a polyether sulfone (PES) film or a polycarbonate (PC) film. The first and second transparent films 2 may be formed of the same material so as to have excellent adhesion performance to each other.

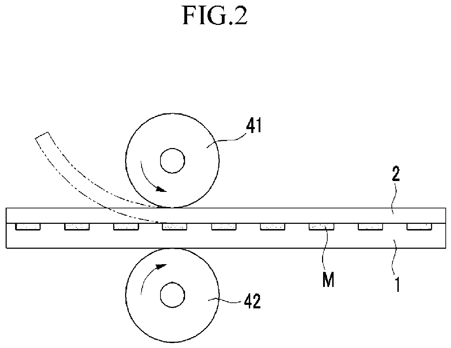

FIG. 2 illustrates a process of laminating a second transparent film on a first transparent film of FIG. 1 by a roll-to-roll manner. Referring to FIG. 2, the laminating step ST4 attaches the first transparent film 1 and the second transparent film 2 forming the partition 11 or the electric device 51 to each other, transports the films between a pressure roll 41 and a support roll 42, and laminates the second transparent film 2 on the first transparent film 1.

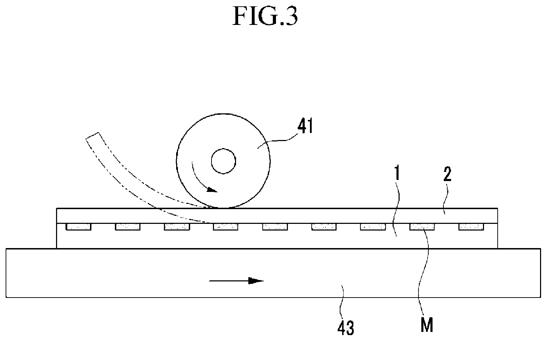

FIG. 3 illustrates a process of laminating the second transparent film on the first transparent film of FIG. 1 by a roll-to-plate manner. Referring to FIG. 3, the laminating step ST4 attaches the first transparent film 1 and the second transparent film 2 forming the partition 11 or the electric device 51 to each other, transports the films between the pressure roll 41 and the support plate 43, and laminates the second transparent film 2 on the first transparent film 1.

FIGS. 4A and 4B are perspective views of a security film manufactured by the manufacturing method of FIG. 1. Referring to FIG. 4B, the security film 10 includes the light blocking portion of the partition 11 formed by the black pigment filled in the fine pattern groove 12 patterned between the first and second transparent films 1 and 2, and a light transmission portion set between the partitions 11. When the security film 10 is attached to the display device, the partition 11 acts as the light blocking portion to have security performance, and the light transmission portion has transmission performance.

In a security film 60 of FIG. 4A, the fine pattern of the groove 12 imprinted on the first transparent film 1 and a partition 61 filled therein are formed to have a straight line shape, and in the security film 10 of FIG. 4B, the fine pattern of the groove 12 imprinted on the first transparent film 1 and the partition 61 filled therein are formed to have a cross shape. The security film 10 of the partition 11 having the cross shape may further set a security direction to left and right or upper and lower directions as compared to the security film 60 of the partition 61 having the straight line shape.

FIG. 5 is a perspective view of a film integral electric device manufactured by the manufacturing method of FIG. 1. Referring to FIG. 5, the film integral electric device 50 includes a conductive portion of the electric device 51 formed of conductive ink filled in the fine pattern groove 12 patterned between the first and second transparent films 1 and 2 and a non-conductive portion set between the electric devices 51.

While this invention has been described in connection with what is presently considered to be practical exemplary embodiments, it is to be understood that the invention is not limited to the disclosed embodiments, but, on the contrary, is intended to cover various modifications and equivalent arrangements included within the scope of the appended claims.

## Claims

1. A method of manufacturing a film product using thermal roll imprinting and blade coating, comprising:
a preparing step of preparing a first transparent film (1);
an imprinting step of transporting the first transparent film (1) between a thermal roll (22) provided with an imprint mask and a support roll (23) to form a groove of a fine pattern on the first transparent film (1); and
a blading step of filling a filling material of a paste state having at least one property of light blocking and conductivity in the groove of the first transparent film (1) by a doctor blade (31),
wherein the thermal roll (22) and the support roll (23) press and support each other in a heated state, and
the first transparent film (1) is capable of being thermally imprinted.

2. The method of manufacturing a film product using thermal roll (22) imprinting and blade coating of claim 1, further comprising:
after the blading step, a laminating step of laminating a second transparent film (2) on the first transparent film (1) to cover the filling material.

3. The method of manufacturing a film product using thermal roll (22) imprinting and blade coating of claim 1, wherein: the preparing step prepares any one of a polyethylene terephthalate (PET) film, a polyethylene naphthalate (PEN) film, a polyether sulfone (PES) film and a polycarbonate (PC) film as the first transparent film (1) to perform surface treatment.

4. The method of manufacturing a film product using thermal roll (22) imprinting and blade coating of claim 1, wherein: the blading step fills a black pigment having a light blocking property in the groove.

5. The method of manufacturing a film product using thermal roll (22) imprinting and blade coating of claim 1, wherein: the blading step fills a conductive ink in the groove.

6. The method of manufacturing a film product using thermal roll (22) imprinting and blade coating of claim 5, wherein: the blading step fills an Ag paste that is the conductive ink in the groove.

7. The method of manufacturing a film product using thermal roll (22) imprinting and blade coating of claim 1, wherein: the doctor blade (31) is formed of any one of a metal blade, a ceramic blade and a squeegee.

8. The method of manufacturing a film product using thermal roll imprinting and blade coating of claim 2, wherein: the laminating step laminates any one of a polyethylene terephthalate (PET) film, a polyethylene naphthalate (PEN) film, a polyether sulfone (PES) film and a polycarbonate (PC) film as the second transparent film (2) by a roll-to-roll or roll-to-plate manner.

9. A security film manufactured by the method according to any one of claims 2,8 comprising:
a first transparent film where a groove of a predetermined fine pattern is formed on one surface thereof by thermal roll imprinting; and
a partition formed by a black pigment filled in the groove,
wherein the first transparent film (1) and the second transparent film (2) are formed of any one of a polyethylene terephthalate (PET) film, a polyethylene naphthalate (PEN) film, a polyether sulfone (PES) film and a polycarbonate (PC) film.

10. A film integral electric device (50) comprising:
the first transparent film having the groove manufactured by the method according to claim 1 or 3;
an electric device (51) formed by conductive ink filled in the groove by blading of the doctor blade; and
a second transparent film (2) covering the electric device to be laminated on the first transparent film (1).

11. The film integral electric device of claim 10, wherein the conductive ink is formed of an Ag paste.

## Patentansprüche

1. Verfahren zum Herstellen eines Folienprodukts unter Verwenden von Thermowalzendrucken und Rakelstreichen, umfassend:
einen Vorbereitungsschritt zum Vorbereiten einer ersten durchsichtigen Folie (1);
einen Druckschritt des Transportierens der ersten durchsichtigen Folie (1) zwischen einer Thermowalze (22), die mit einer Druckmaske versehen ist, und einer Stützwalze (23) zum Bilden einer Nut eines feinen Musters auf der ersten durchsichtigen Folie (1); und
einen Streichstritt zum Einfüllen eines Füllmaterials mit einem pastösen Zustand, das eine Eigenschaft des Blockierens von Licht und/oder Leitfähigkeit hat, in der Nut der ersten durchsichtigen Folie (1), anhand einer Rakel (31),
wobei die Thermowalze (22) und die Stützwalze (23) in einem erhitzten Zustand aneinander pressen und einander stützen, und
wobei die erste durchsichtige Folie (1) fähig ist, thermisch bedruckt zu werden.

2. Verfahren zum Herstellen eines Folienprodukts unter Verwenden von Thermowalzen (22)-Drucken und Rakelstreichen nach Anspruch 1, ferner umfassend:
nach dem Streichschritt einen Laminierungsschritt zum Laminieren einer zweiten durchsichtigen Folie (2) auf der ersten durchsichtigen Folie (1), um das Füllmaterial abzudecken.

3. Verfahren zum Herstellen eines Folienprodukts unter Verwenden von Thermowalzen (22)-Drucken und Rakelstreichen nach Anspruch 1, wobei: der Vorbereitungsschritt eine beliebige einer Polyethylenterephthalatfolie (PET), einer Polyethylennaphthalatfolie (PEN), einer Polyethersulfonfolie (PES) und einer Polycarbonatfolie (PC) als die erste durchsichtige Folie (1) vorbereitet, um Oberflächenbehandlung auszuführen.

4. Verfahren zum Herstellen eines Folienprodukts unter Verwenden von Thermowalzen (22)-Drucken und Rakelstreichen nach Anspruch 1, wobei: der Streichschritt ein schwarzes Pigment, das eine Licht blockierende Eigenschaft hat, in die Nut einfüllt.

5. Verfahren zum Herstellen eines Folienprodukts unter Verwenden von Thermowalzen (22)-Drucken und Rakelstreichen nach Anspruch 1, wobei: der Streichschritt eine leitfähige Tinte in die Nut einfüllt.

6. Verfahren zum Herstellen eines Folienprodukts unter Verwenden von Thermowalzen (22)-Drucken und Rakelstreichen nach Anspruch 5, wobei: der Streichschritt eine Ag-Paste, die die leitfähige Tinte ist, in die Nut einfüllt.

7. Verfahren zum Herstellen eines Folienprodukts unter Verwenden von Thermowalzen (22)-Drucken und Rakelstreichen nach Anspruch 1, wobei: die Rakel (31) aus einer beliebigen einer Metallklinge, einer Keramikklinge und einer Gummirakel besteht.

8. Verfahren zum Herstellen eines Folienprodukts unter Verwenden von Thermowalzendrucken und Rakelstreichen nach Anspruch 2, wobei: der Laminierungsschicht eine beliebige einer Polyethylenterephthalatfolie (PET), einer Polyethylennaphthalatfolie (PEN), einer Polyethersulfonfolie (PES) und einer Polycarbonatfolie (PC) als die zweite durchsichtige Folie (2) auf eine Walze-zu-Walze- oder Walze-zu-Plattenart laminiert.

9. Sicherheitsfolie, die durch das Verfahren nach einem der Ansprüche 2, 8 hergestellt wird, umfassend:
eine erste durchsichtige Folie, wobei eine Nut mit einem vorbestimmten feinen Muster auf einer ihrer Oberflächen durch Thermowalzendrucken gebildet wird; und
eine Partition, die durch ein schwarzes Pigment, das in die Nut gefüllt wird, gebildet wird,
wobei die erste durchsichtige Folie (1) und die zweite durchsichtige Folie (2) aus einer beliebigen einer Polyethylenterephthalatfolie (PET), einer Polyethylennaphthalatfolie (PEN), einer Polyethersulfonfolie (PES) und einer Polycarbonatfolie (PC) gebildet sind.

10. Integrale elektrische Folienvorrichtung (50), umfassend:
die erste durchsichtige Folie, die die Nut hat, die durch das Verfahren nach Anspruch 1 oder 3 hergestellt wird;
eine elektrische Vorrichtung (51), die durch leitfähige Tinte gebildet wird, die in die Nut durch Streichen der Rakel eingefüllt wird; und
eine zweite durchsichtige Folie (2), die die elektrische Vorrichtung, die auf die erste durchsichtige Folie (1) zu laminieren ist, abdeckt.

11. Integrale elektrische Folienvorrichtung nach Anspruch 10, wobei die leitfähige Tinte aus einer Ag-Paste gebildet ist.

## Revendications

1. Procédé de fabrication d'un produit de film en utilisant une impression par rouleau thermique et un couchage à la lame, comprenant :
une étape de préparation qui consiste à préparer un premier film transparent (1) ;
une étape d'impression qui consiste à transporter le premier film transparent (1) entre un rouleau thermique (22) muni d'un masque d'impression et un rouleau de support (23) pour former une rainure ayant un motif fin sur le premier film transparent (1) ; et
une étape de raclage qui consiste à remplir, par une racle (31), la rainure du premier film transparent (1) d'un matériau de remplissage ayant un état pâteux présentant au moins une propriété de blocage de lumière et une conductivité,
dans lequel le rouleau thermique (22) et le rouleau de support (23) s'appuient et se supportent mutuellement dans un état chauffé, et
le premier film transparent (1) est capable d'être imprimé thermiquement.

2. Procédé de fabrication d'un produit de film en utilisant une impression par rouleau thermique (22) et un couchage à la lame de la revendication 1, comprenant en outre :
après l'étape de raclage, une étape de stratification qui consiste à stratifier un deuxième film transparent (2) sur le premier film transparent (1) pour couvrir le matériau de remplissage.

3. Procédé de fabrication d'un produit de film en utilisant une impression par rouleau thermique (22) et un couchage à la lame de la revendication 1, dans lequel : l'étape de préparation permet de préparer l'un quelconque d'un film de polyéthylène téréphtalate (PET), d'un film de polyéthylène naphtalate (PEN), d'un film de polyéther sulfone (PES) et d'un film de polycarbonate (PC) comme étant le premier film transparent (1) pour effectuer un traitement de surface.

4. Procédé de fabrication d'un produit de film en utilisant une impression par rouleau thermique (22) et un couchage à la lame de la revendication 1, dans lequel : l'étape de raclage permet de remplir la rainure d'un pigment noir ayant une propriété de blocage de lumière.

5. Procédé de fabrication d'un produit de film en utilisant une impression par rouleau thermique (22) et un couchage à la lame de la revendication 1, dans lequel : l'étape de raclage permet de remplir la rainure d'une encre conductrice.

6. Procédé de fabrication d'un produit de film en utilisant une impression par rouleau thermique (22) et un couchage à la lame de la revendication 5, dans lequel : l'étape de raclage permet de remplir la rainure d'une pâte Ag qui est l'encre conductrice.

7. Procédé de fabrication d'un produit de film en utilisant une impression par rouleau thermique (22) et un couchage à la lame de la revendication 1, dans lequel : la racle (31) est formée de l'une quelconque d'une lame métallique, d'une lame céramique et d'une raclette.

8. Procédé de fabrication d'un produit de film en utilisant une impression par rouleau thermique et un couchage à la lame de la revendication 2, dans lequel : l'étape de stratification permet de stratifier l'un quelconque d'un film de polyéthylène téréphtalate (PET), d'un film de polyéthylène naphtalate (PEN), d'un film de polyéther sulfone (PES) et d'un film de polycarbonate (PC) comme étant le deuxième film transparent (2) dans un mode rouleau à rouleau ou rouleau à plaque.

9. Film de sécurité fabriqué par le procédé selon l'une quelconque des revendications 2 à 8, comprenant :
un premier film transparent dans lequel une rainure ayant un motif fin prédéterminé est formée sur une surface de celui-ci par impression par rouleau thermique ; et
une cloison formée par un pigment noir remplissant la rainure,
dans lequel le premier film transparent (1) et le deuxième film transparent (2) sont formés de l'un quelconque d'un film de polyéthylène téréphtalate (PET), d'un film de polyéthylène naphtalate (PEN), d'un film de polyéther sulfone (PES) et d'un film de polycarbonate (PC).

10. Dispositif électrique intégré au film (50) comprenant :
le premier film transparent ayant la rainure fabriqué par le procédé selon la revendication 1 ou 3 ;
un dispositif électrique (51) formé par une encre conductrice remplissant la rainure par raclage de la racle ; et
un deuxième film transparent (2) couvrant le dispositif électrique à stratifier sur le premier film transparent (1).

11. Dispositif électrique intégré au film de la revendication 10, dans lequel l'encre conductrice est formée d'une pâte Ag.
